# EUROPEAN PATENT APPLICATION

(11) **EP 4 821 817 A1**
(43) Date of publication of application: **14.10.2026**
(21) Application number: 26170546.1
(22) Date of filing: 02.04.2026
(51) Int. Cl.: B64D 11/06, B64F 5/10, B64D 11/00

(54) **ATTENDANT MODULE FOR CHARGING A PERSONAL ELECTRONIC DEVICE**

(30) Priority: 10.04.2025 US 202519175179
(71) Applicant: The Boeing Company, Arlington, VA 22202 (US)
(72) Inventor: RITTENHOUSE, Timothy Dale, Jr., 22202 ARLINGTON (FR); BECKFORD, Jason Anthony, ARLINGTON, 22202 (US); CLIFTON, David William, ARLINGTON, 22202 (US); HUSACK, Shane Nicholas, ARLINGTON, 22202 (US); HUNT, Belinda Dang, ARLINGTON, 22202 (US)
(74) Representative: Plasseraud IP

(57) **Abstract**

An attendant module configured to be mounted to a monument within a fuselage of an aircraft and configured to enable charging of a personal electronic device. The attendant module has a first compartment extends into a first side of the body. A first door is connected to the body at the first compartment. One or more holsters are mounted to the inner face of the first door with each of the holsters configured to hold the personal electronic device. A second compartment extends into a second side of the body. One or more electrical ports are positioned in the second compartment. A second door is connected to the body at the second compartment and movable between open and closed positions with the second door sized to extend across the second compartment in a closed position.

## Description

### TECHNOLOGICAL FIELD

The present disclosure relates generally to the field of aircraft and, more specifically, to an attendant module for the interior of the aircraft configured to connect to and charge a personal electronic device.

### BACKGROUND

It is often necessary for flight personnel to charge their personal electronic devices during a flight. Examples of personal electronic devices include airline laptop computers and tablets as well as their own personnel cell phones and other hand-held computer devices. Currently it is difficult for flight personnel to charge their electronic devices while on an aircraft.

Attendants spend a large portion of their time during flight in an attendant area, such as a galley in the front or rear of the cabin area. The attendant areas are equipped for a variety of functions to cater to the passengers, such as equipment for preparing and serving food and drinks. These areas can also be configured to control various electrical equipment in the cabin area, such as video and audio equipment. However, these attendant areas are not equipped with charging equipment.

Another issue is if charging can occur in the work areas, it includes the electronic equipment to be placed on a work surface. For example, the electronic equipment is placed on a counter where the person is preparing food and drinks. This results in the equipment getting in the way of performing their duties during the flight. Further, the electronic equipment is exposed which could enable a person to look at their private information and/or possibly steal the electronic device. Placement of the electronic devices on a work surface while charging could also pose a potential safety issue in the event the aircraft experienced turbulence during the flight. Further, this placement may not conform to various regulatory requirements for fire safety on aircraft.

### SUMMARY

One aspect is directed to an attendant module configured to be mounted to a monument within a fuselage of an aircraft and configured to enable charging of a personal electronic device. The attendant module comprises a body. A first compartment extends into a first side of the body. A first door is connected to the body at the first compartment with the first door comprising an outer face and an inner face and configured to move relative to the body between an open position and a closed position. One or more holsters are mounted to the inner face of the first door with each of the holsters configured to hold the personal electronic device. A second compartment extends into a second side of the body. One or more electrical ports are positioned in the second compartment. A second door is connected to the body at the second compartment and movable between open and closed positions with the second door sized to extend across the second compartment in a closed position.

In another aspect, the first door and the second door open in different directions.

In another aspect, the first door is connected to the body at a first hinge and the second door is connected to the body at a second hinge, with the first hinge aligned horizontally along the body and the second hinge is aligned vertically along the body.

In another aspect, the body comprises a front side and a back side with the first compartment extending into the front side and the first door connected to the front side, electrical components mounted to the back wall within an interior of the body; and a panel mounted within the interior of the body with the panel positioned between the first compartment and the electrical components.

In another aspect, a frame is mounted within an interior of the body with the frame comprising a back member, arms that extend outward from opposing sides of the back member, wherein the first compartment is positioned between the arms, and wherein the second compartment is positioned on outward from one of the arms such that the arm extends between the first compartment and the second compartment.

In another aspect, a third compartment that extends into the first side of the body with a third door connected to the body at the third compartment and movable between an open position and a closed position.

In another aspect, the first door is positioned at an opening of the first compartment and the first door is smaller than the opening to form a gap between the body and the first door when the first door is in the closed position, the gap configured to enable smoke in the first compartment to exit from the first compartment when the first door is in the closed position.

In another aspect, input devices on the body to control video electronics that are positioned within the interior of the body.

In another aspect, a swing range of the first door is less than 90° so a top edge of the first door remains vertically above a bottom edge of the first door in the open position.

One aspect is directed to an attendant module configured to be mounted to a monument within a fuselage of an aircraft and configured to enable charging of a personal electronic device. The attendant module comprises a body comprising an interior space positioned within a front side, lateral sides, a top side, a bottom side. A frame is mounted within the interior space of the body with the frame comprising opposing arms. A first compartment extends into the front side of the body between the opposing arms of the frame. A first door is connected to the opposing arms of the frame at the front side of the body. A second compartment extends into one of the lateral sides of the body on an outside of one of the opposing arms. A second door connected to the frame at the one lateral side of the body. One or more electrical ports are positioned in the second compartment. One or more holsters are mounted to an inner side of the first door with each of the holsters configured to receive the personal electronic device. Wherein the first compartment and the second compartment are on opposing sides of the frame.

In another aspect, hinges of the first door and the second door are aligned in different orientations with the first door and the second door configured to move in opposing directions between open and closed positions.

In another aspect, the one or more holsters comprise an open end that is positioned at a top edge of the first door, wherein the first door is pivotally mounted to the frame for the top edge to be vertically above a bottom edge when the first door is in an open position.

In another aspect, video electronics positioned are within the interior space of the body, a panel is positioned within the interior space of the body, and the panel is positioned between the video electronics and the first compartment to segregate the first compartment from the video electronics.

In another aspect, the panel is mounted to the frame and vertically aligned within the interior space.

In another aspect, input devices are positioned on an exterior of the body with the input devices configured to operate the video electronics.

In another aspect, a gap is formed between the first door and the first compartment when the first door is in a closed position with the gap sized to enable smoke in the first compartment from existing the first compartment when the first door is in the closed position.

One aspect is directed to a method of mounting an attendant module to a monument within a cabin area of an aircraft. The method comprises: mounting a frame to a base that is mounted to the monument with the base comprising electrical equipment configured to operate components that are within the cabin area; mounting a panel to the frame with the panel positioned in front of the electrical equipment; mounting a body of the attendant module to the base; aligning a first opening of the body along a front side of the attendant model and in front of the panel; aligning a second opening of the body along a lateral side of the attendant model at an electrical port; positioning a first door at the first opening with the first door movable to a closed position that extends across the first opening; and positioning a second door at the second opening with the second door movable to a closed position that extends across the second opening.

In another aspect, mounting the body to the base comprises positioning the body over the frame and over the panel.

In another aspect, the method further comprises aligning a first hinge of the first door along a bottom of the first door, and aligning a second hinge of the second door along a lateral side of the second door.

In another aspect, the method further comprises positioning input devices along an outer section of the body with the input devices configured to control the electrical equipment and operate components that are within the cabin area.

One aspect is directed to a method of charging a portable electronic device at an attendant module that is mounted to a wall of an interior of an aircraft. The method comprises: opening a first door of the attendant module in a first direction and exposing a holster that is mounted to the first door; opening a second door of the attendant module in a second direction and exposing an electrical port; attaching a charging cable to each of the electrical port and the portable electronic device; inserting the portable electronic device into the holster on the first door; and closing the first door while the charging cable is connected to the portable electronic device and charging the portable electronic device.

In another aspect, the method further comprises closing the second door while the charging cable is connected to the electrical port.

In another aspect, the method further comprises opening the first door and positioning the first door in an upright position with a top edge of the first door vertically above a bottom edge of the first door.

In another aspect, the method further comprises forming a gap between the first door and a body of the attendant module when the first door is in the closed position.

The features, functions and advantages that have been discussed can be achieved independently in various aspects or may be combined in yet other aspects, further details of which can be seen with reference to the following description and the drawings.

### BRIEF DESCRIPTION OF THE DRAWINGS

Figure 1 is an isometric view of an aircraft.
Figure 2 is a schematic section view of an interior of a fuselage that includes multiple attendant modules.
Figure 3 is a schematic diagram of an attendant module configured to connect with a charging cable to charge an electronic device.
Figure 4A is an isometric view of an attendant module with a first door and a second door in closed positions.
Figure 4B is an isometric view of the attendant module of Figure 4A with the first door and the second door in open positions.
Figure 5 is a front view of a holster that is mounted to a door and is supporting a personal electronic device.
Figure 6 is an isometric view of components configured to be positioned within an interior space of an attendant module.
Figure 7 is an isometric view of a frame.
Figure 8 is a side view of a door of an attendant module in an open position to access holsters configured to hold electronic devices.
Figure 9 is a method of charging a portable electronic device at an attendant module in an aircraft.
Figure 10 is a method of mounting an attendant module to a monument within a cabin area of an aircraft.

### DETAILED DESCRIPTION

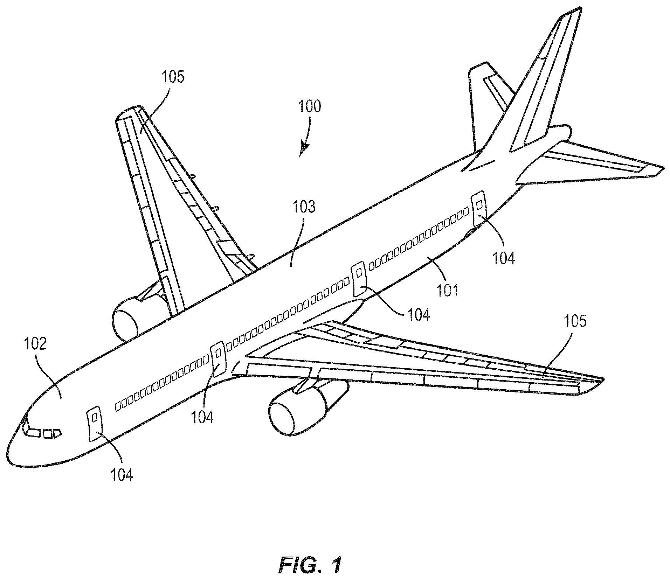

Figure 1 illustrates an aircraft 100 that generally includes a fuselage 101 and wings 105. A flight deck 102 is positioned at a front of the fuselage 101 and a cabin area 103 is positioned rearward. The cabin area 103 is equipped for accommodating passengers and/or cargo. The size of the flight deck 102 and the cabin area 103 can vary depending upon the aircraft 100. One or more exterior doors 104 provide for passengers and flight personnel to enter and exit the fuselage 101.

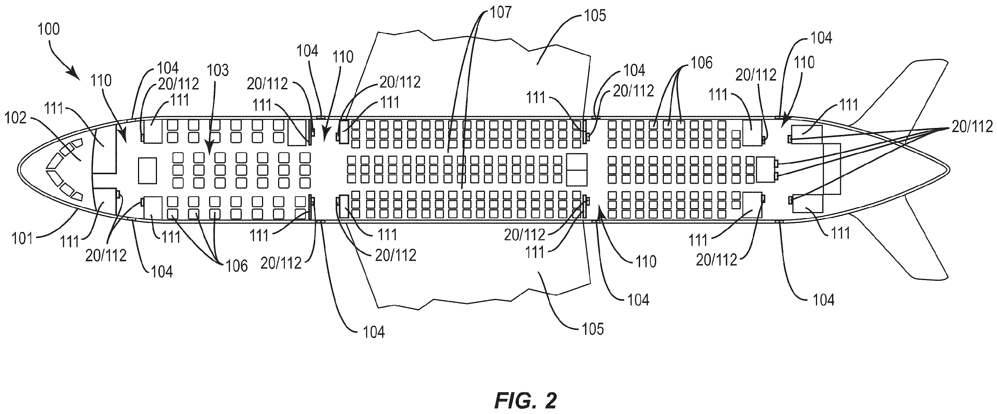

Figure 2 illustrates an interior of the fuselage 101. The cabin area 103 is positioned along the fuselage 101 rearward of the flight deck 102. The cabin area 103 includes seats 106 arranged in rows along one or more aisles 107. In some examples such as a commercial airline, the seats 106 extend throughout the cabin area 103. In other examples in which the aircraft 100 is used for cargo transport, a limited number of seats 106 are positioned in the cabin area 103.

The cabin area 103 also includes one or more attendant areas 110. The attendant areas 110 include one or more monuments 111 that are mounted to the structural members of the aircraft 100 within the fuselage 101. The monuments 111 are functional units with examples including but not limited to galleys, lavatories, and stowage units. Figure 2 includes four attendant areas 110 with a foreward attendant area 110, two intermediate attendant areas 110, and a rear attendant area 110. Attendant seats 112 are positioned in one or more of the attendant areas 110. The attendant seats 112 are configured to enable the attendants to sit, such as during takeoffs, landings, and turbulence. One or more attendant modules 20 are positioned in the attendant areas 110. In some examples, the attendant modules 20 are positioned in proximity to the attendant seats 112 to enable flight personnel to access an attendant module 20 while seated. In some examples, the attendant modules 20 are positioned vertically above the attendant seats 112. In other examples, the attendant modules 20 are horizontally offset from the seats 112.

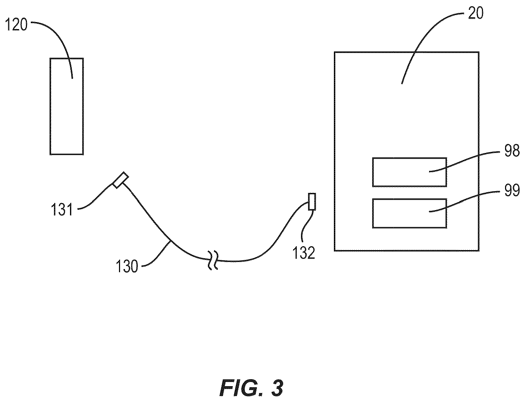

As illustrated in Figure 3, the attendant module 20 enables electrical charging of personal electronic devices 120. In some examples, the personal electronic devices 120 include but is not limited to cell phones, tablets, computers, smartwatches, MP3 players, and cameras. The attendant modules 20 are configured to connect to a charging cable 130 to charge the personal electronic devices 120. In some examples, an attendant module 20 is positioned in proximity to the attendant seats 112 to enable the flight personnel to access and charge their personal electronic device 120 when seated. In other examples, the attendant modules 20 are placed at other locations within the attendant areas 110.

The attendant module 20 also includes electrical equipment 99. In some examples, the electrical equipment 99 is configured to operate one or more functional units within the cabin area 103, such as but not limited to an audio system, display system (i.e., display screens at the passenger seats 106), and air supply system. One or more input devices 98 such as but not limited to switches, control knobs, keyboards, and touch screens are exposed on the attendant module 20 for flight personnel to operate the electrical equipment 99. Additionally or alternatively, the electrical equipment 99 includes an inverter to supply AC power from one or more DC sources.

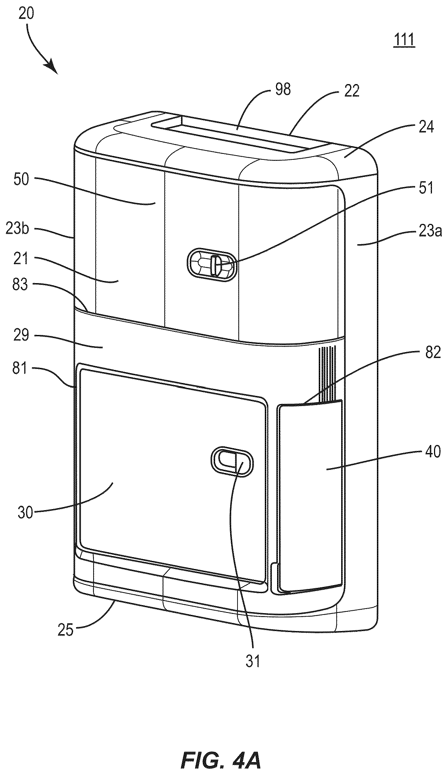

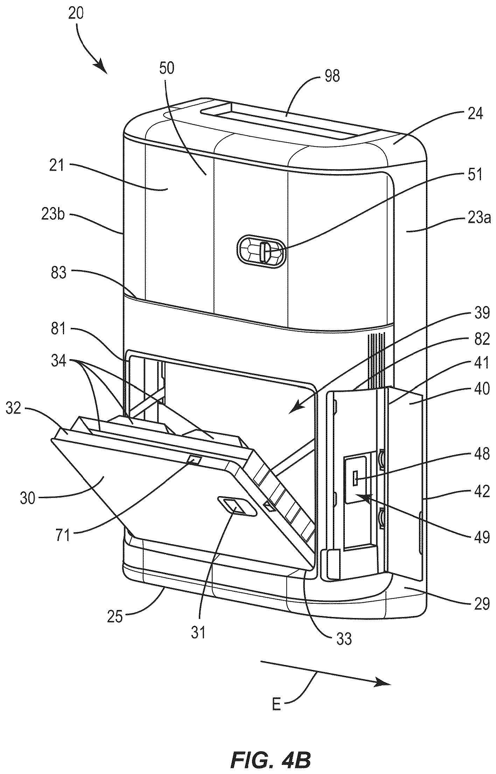

Figures 4A and 4B illustrate an attendant module 20 that is mounted to a monument 111. The attendant module 20 includes a body 29 with a front side 21, a back side 22, lateral sides 23, top side 24, and a bottom side 25. The back side 22 is configured to abut against the monument 111 with the other sides exposed. The attendant module 20 is configured to enable electrical charging of personal electronic devices 120. In some examples, the attendant module 20 is further configured to include storage to receive objects, such as items belonging to the flight personnel or items used during flight. In some examples, the attendant module 20 is configured to store emergency equipment. Input devices 98 enable controlling one or more functional systems within the cabin area 103.

The body 29 of the attendant module 20 includes a pair of openings 81, 83 at the front side 21, and an opening 82 at the lateral side 23. The attendant module 20 includes a door 30 at the opening 81 on the front side 21. The door 30 provides access to a first compartment 39 within the interior space 28 of the attendant module 20. The door 30 includes a manual latch 31 to be selectively secure the door 30 in the closed position as illustrated in Figure 4A, or to be released to enable moving the door 30 to an open position as illustrated in Figure 4B. The door 30 is pivotally mounted at a lower edge 33. The top edge 32 is positioned away from the body 29 in the open position and positioned in a vertically upright position at the body 29 in the closed position.

In some examples as illustrated in Figure 4A, the door 30 is smaller than the opening 81 of the compartment 39. This difference in sizing causes a gap 70 to be formed between the outer edge of the door 30 and the body 29 when the door 30 is in the closed position. The size of the gap 70 can vary, with one example having a size of about 0.125". The gap 70 enables smoke to exit from the compartment 39 when the door 30 is in the closed position in the event there is an issue with the personal electronic device 120 during charging. In some examples, one or more slots 71 are formed in the outer edge of the door 30. The slots 71 receive the charging cable 130 and enable the door 30 to close when charging a personal electronic device 120.

One or more holsters 34 are positioned on the inner side of the door 30. The holsters 34 are configured to securely hold the personal electronic device 120 during charging.

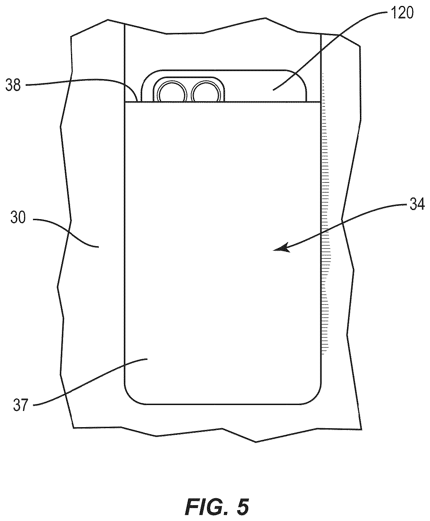

Figure 5 illustrates a holster 34 that is mounted on the inner side of door 30. The holster 34 includes a body 37 that is configured to extend around the personal electronic device 120. The body 37 includes an opening 38 at a top end and a closed bottom. The opening 38 leads into the interior of the body 37 for inserting and removing the personal electronic device 120. In one examples, the holster 34 is constructed from a mesh material that is flexible to accommodate a variety of different personal electronic devices 120.

The holster 34 is mounted to the door 30 with the opening 38 positioned towards the top edge 32. This causes the personal electronic device 120 to be vertically aligned and seated against the closed bottom when the door 30 is in the open and closed positions. The number of holsters 34 positioned on the door 30 can vary. In one specific example as illustrated in Figure 4B, two holsters 34 are mounted to the door 30. In some examples, one or more holsters 34 are mounted in the compartment 39 away from the door 30. In examples with multiple holsters 34, the holsters 34 can have the same or different sizes. In some examples as illustrated in Figures 4B, 6, and 8, one or more of the holsters 34 are smaller and configured to hold a first type of device 120 (e.g., cell phone) and one or more of the holsters 34 are configured to hold a larger device (e.g., laptop computer, notepad computer).

The attendant module 20 also includes a door 40 at the opening 82 on the lateral side 23 at a second compartment 49. The door 40 extends over the one or more electrical ports 48 in the compartment 49. The door 40 is movable between a closed position as illustrated in Figure 4A and an open position as illustrated in Figure 4B. In some examples as illustrated in Figure 4A and 4B, the door 40 is positioned on a first lateral side 23a. Other examples include the door 40 on the opposing lateral side 23b, the top side 24, or the bottom side 25. In other examples, two or more doors 40 are mounted on different sides of the attendant module 20 (e.g., doors 40 mounted on both lateral sides 24a, 24b).

The door 40 is pivotally connected to the body 29. The door 40 opens towards the back side 22 with a back edge 41 remaining substantially at the same position and a front edge 42 outward away from the body 29 in the open position. This configuration enables the flight personnel to access the one or more electrical ports 48 when the door 40 is in the open position as the door 40 is not directly between the ports 48 and the compartment 39. This configuration also protects the door 40 when in the open position as it is less likely to be contacted and potentially damaged by a person walking by the attendant module 20. In some examples, the door 40 includes a lip, ball-and-detent, or other like mechanical configuration to secure the door 40 in the closed position. The electrical ports 48 can include a variety of different configurations with examples including but not limited to a universal serial bus (USB) port and an electrical socket.

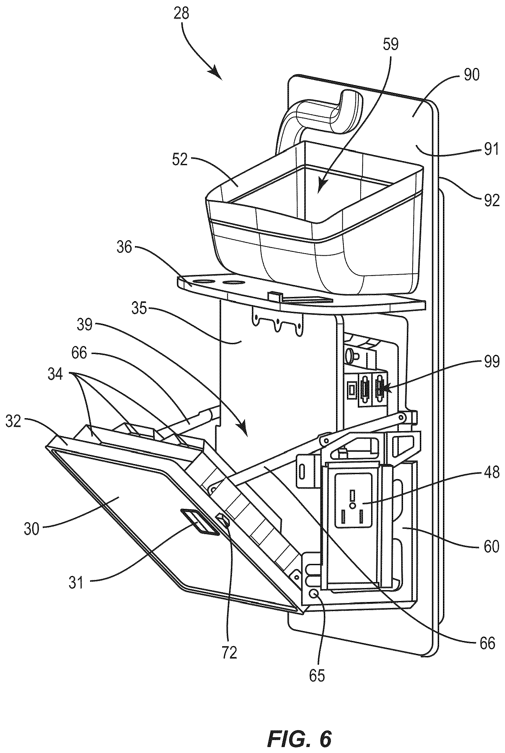

Attendant module 20 also includes a door 50 positioned at the opening 83 on the front side 21 and away from the door 30. The door 50 is configured to extend over a compartment 59. In some examples as illustrated in Figure 6, the compartment 59 includes a bin 52 with walls configured to contain items. In one example, the walls of the bin 52 are continuous to contain fluid in the event of a leak (e.g., leaking bottle of hand sanitizer). The door 50 includes a manual latch 51 to secure the door 50 in the closed position.

Figure 6 illustrates components of the attendant module 20 that are positioned within the interior space 28. A base 90 forms a back wall of the interior space 28. The base 90 is rigid and forms a foundation for mounting one or more of the components that are in the interior space 28. The base 90 includes substantially flat front and rear sides 91, 92. In some examples, the rear side 92 is mounted directly to the monument 111. In other examples, one or more intermediate members are positioned between the rear side 92 and the monument 111. The electrical equipment 99 is mounted to the front side 91. A panel 35 is positioned between the electrical components 99 and the door 30. The panel 35 forms the back wall of the compartment 39. The panel 35 prevents flight personnel from inadvertently contacting the electrical equipment 99 when reaching into the compartment 39 when the door 30 is in the open position. The bin 52 is mounted to the base 90 at the door 50. A second panel 36 is positioned underneath the bin 52. Panel 36 prevents inadvertent contact with the electrical equipment 99 when the door 50 is open. Panel 36 also segregates the compartments 39, 59. **In** some examples, the different wall members 35, 36 are connected together to provide a continuous wall. The panels 35, 36 also prevent items that are stored in the compartments 39, 59 from contacting the electrical equipment 99.

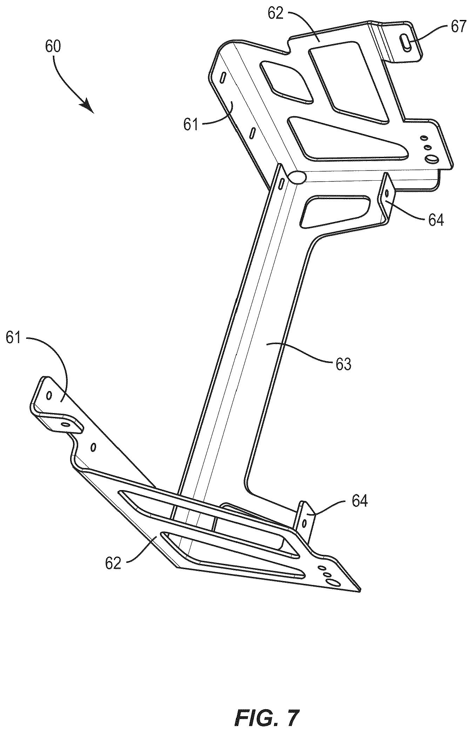

A frame 60 is mounted to the base 90 and configured to support the door 30. As illustrated in Figures 6, 7, and 8, the frame 60 includes back members 61 that abut against the base 90. Openings in the back members 61 are configured to receive fasteners that connect to the base 90. Arms 62 extend outward on opposing lateral sides. A bottom member 63 extends between the back members 61 and the arms 62. The bottom member 63 contacts against and supports the panel 35. **In** some examples, flanges 64 on the bottom member 63 include openings to receive fasteners to connect the bottom member 63 to the panel 35.

The door 30 is connected to the arms 62 at a hinge 65 that is positioned in proximity to the bottom edge 33. The hinge 65 is formed by connections between the door 30 and arms 62. The frame 60 also includes an opening 67 formed in one of the arms 62. The opening 67 is configured to receive a bolt 72 of the latch 31 on the door 30. This provides for the door 30 to be secured in the closed position when the door 30 is mounted to the frame 60.

Support members 66 extend between the frame 60 and the door 30 to provide additional support. The support members 66 are connected to the door 30 in closer proximity to the top edge 32 than the bottom edge 33. The support members 66 are connected from multiple sections that are pivotally connected together. When the door 30 is in the open position as illustrated in Figures 4 and 6, the sections are in an unfolded orientation to enable the top edge 32 to be positioned outward. **In** the closed position, the sections are folded to enable the movement. **In** some examples, the support members 66 include two sections. An angle formed between the two sections is less than 180° (i.e., the two sections are not coaxially aligned). This offset alignment prevents the sections from binding in the open position.

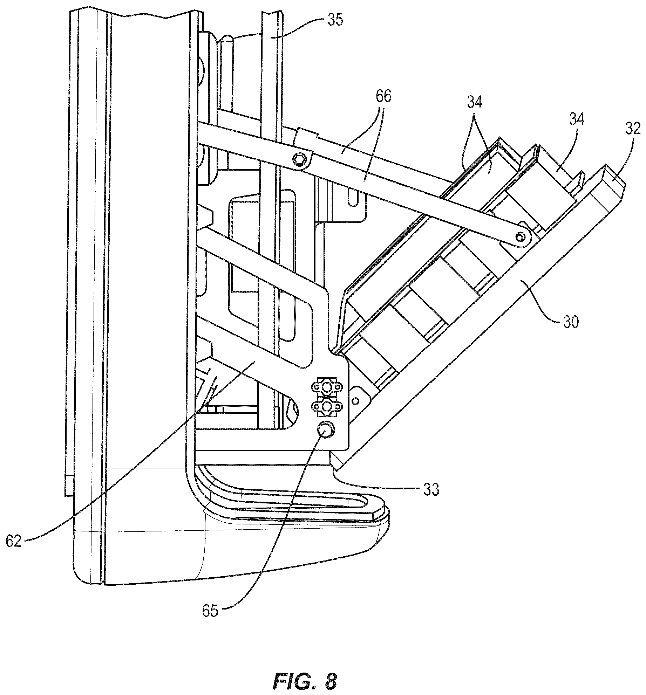

As best illustrated in Figure 8, the door 30 angles outward in the open position. The top edge 32 is positioned a greater distance away from the panel 35 than the bottom edge 33. This position facilitates a personal electronic device to fully insert into the holster 34 as gravity causes it to slide towards the bottom of the holster 34 and away from the open end 38.

The compartment 39 at the first door 30 is positioned between the arms 62 of the frame 60. The compartment 49 at the second door 40 is positioned on the outer side of the arms 62 of the frame 60. This ensures that the one or more electrical ports 48 at the compartment 49 are positioned away from the compartment 39.

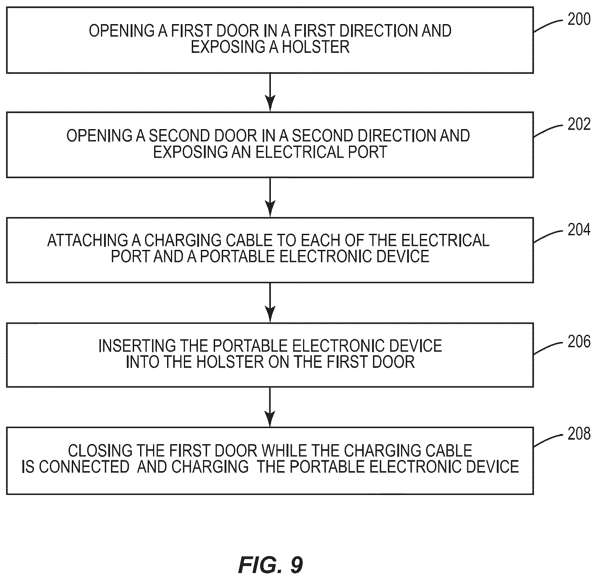

Figure 9 illustrates a method of charging a portable electronic device 120 at an attendant module 20 that is mounted to a wall of an aircraft 100. A first door 30 of the attendant module 20 is opened in a first direction to expose a holster 34 that is mounted to the first door 30 (block 200). A second door 40 of the attendant module 20 is opened in a second direction to expose an electrical port 48 (block 202). A charging cable 130 is attached to each of the electrical port 48 and the portable electronic device 120 (block 204). The portable electronic device 120 is inserted into the holster 34 on the first door 30 (block 206). The first door 30 is closed while the charging cable 130 is connected to the portable electronic device 120 and the portable electronic device 120 is being charged (block 208).

The attendant module 20 can be positioned at various locations within the aircraft 100. In one example, the attendant module 20 is positioned for the door 40 that extends over the one or more electrical ports 48 opens in an outboard direction. This provides for egress of persons on the aircraft 100 and prevents the door 40 from potentially blocking an exit route. This aspect is illustrated in Figure 4B with the door 40 opening in an outboard direction. This provides for the door 40 to be positioned away from persons moving towards an exit in a direction E past the attendant module 20.

In some examples, the attendant module 20 is a contained unit that is mounted to a monument in the attendant area 110. In other examples, the attendant module 20 replaces existing equipment that is mounted in the attendant area 110, such as a video console that controls the video equipment in the cabin area 103. The existing equipment includes the base 90 that is mounted to the monument 111, and electrical equipment 99 that is configured to operate the video equipment in the cabin area 103.

The installation of the attendant module 20 includes mounting the frame 60 to the base 90. The panel 35 is mounted to the frame 60 and is positioned in a vertical orientation in front of the electrical equipment 99. A first compartment 39 is formed at the front side of the attendant module 20 in front of the panel 35. A second compartment 49 is formed at the lateral side of the attendant module 20. The second compartment is positioned at an electrical port 48 that is mounted on an outer side of the frame 60.

The body 29 of the attendant module 20 is connected to the base 90. The body 29 extends over the frame 60 and the panel 35. The body 29 includes an opening 81 at the first compartment 39 and another opening 82 at the second compartment 49. The first door 30 is positioned at the first opening 81 and the second door 40 is positioned at the second opening 82. The doors 30, 40 are movable between open and closed positions.

In some examples, the body 29 includes a third opening 83 that aligns with a bin 52 that is connected to the base 90. The door 50 is positioned at the third opening 83.

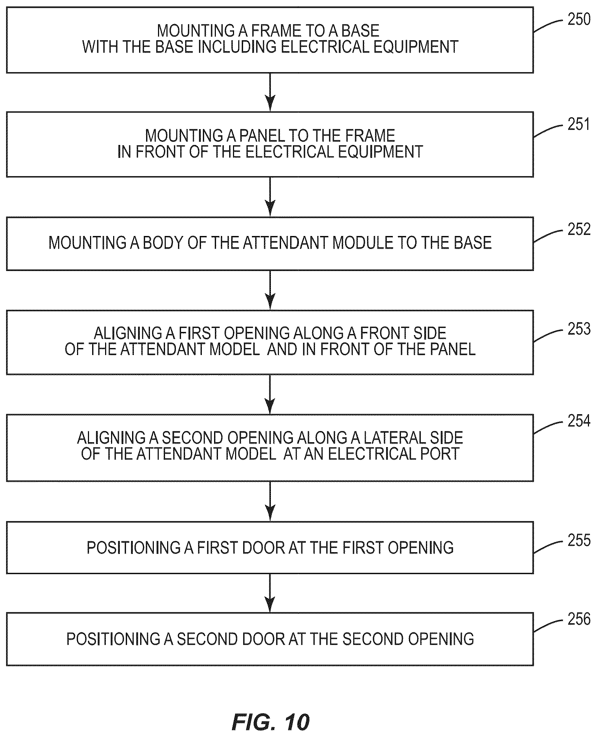

Figure 10 illustrates a method of mounting an attendant module 20 to a monument 111 within a cabin area 103. A frame 60 is mounting to a base 90 on the monument 111 (block 250). The base 90 includes electrical equipment 99 configured to operate components that are within the cabin area 103. A panel 35 is mounted to the frame 60 in front of the electronic equipment 99 (block 251). A body 29 of the attendant module 20 is mounted to the base (block 252). A first opening 81 of the body 29 is aligned along a front side 21 of the attendant model 20 and in front of the panel 35 (block 253). A second opening 82 is aligned along a lateral side 23 of the attendant model 20 at an electrical port 48 (block 254). A first door 30 is positioned at the first opening 81 (block 255). The first door 30 is movable to a closed position that extends across the first opening 81. A second door 40 is positioned at the second opening 82 (block 256). The second door 40 is movable to a closed position that extends across the second opening 82.

By the term "substantially" with reference to amounts or measurement values, it is meant that the recited characteristic, parameter, or value need not be achieved exactly. Rather, deviations or variations, including, for example, tolerances, measurement error, measurement accuracy limitations, and other factors known to those skilled in the art, may occur in amounts that do not preclude the effect that the characteristic was intended to provide.

Spatially relative terms such as "under", "below", "lower", "over", "upper", and the like, are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

The present invention may, of course, be carried out in other ways than those specifically set forth herein without departing from essential characteristics of the invention. The present embodiments are to be considered in all respects as illustrative and not restrictive, and all changes coming within the meaning and equivalency range of the appended claims are intended to be embraced therein.

The present invention may, of course, be carried out in other ways than those specifically set forth herein without departing from essential characteristics of the invention. The present embodiments are to be considered in all respects as illustrative and not restrictive, and all changes coming within the meaning and equivalency range of the appended claims are intended to be embraced therein.

## Claims

1. An attendant module configured to be mounted to a monument within a fuselage of an aircraft and configured to enable charging of a personal electronic device, the attendant module comprising:
a body (29);
a first compartment (39) that extends into a first side of the body (29);
a first door (30) connected to the body (29) at the first compartment (39), the first door (30) comprising an outer face and an inner face, and configured to move relative to the body (29) between an open position and a closed position;
one or more holsters (34) mounted to the inner face of the first door (30), each of the holsters (34) configured to hold the personal electronic device;
a second compartment (49) that extends into a second side of the body (29);
one or more electrical ports (48) positioned in the second compartment (49); and
a second door (40) connected to the body (29) at the second compartment (49) and movable between open and closed positions, the second door (40) sized to extend across the second compartment (49) in the closed position.

2. The attendant module of claim 1, wherein the first door (30) and the second door (40) open in different directions.

3. The attendant module of claim 2, wherein the first door (30) is connected to the body (31) at a first hinge and the second door (40) is connected to the body at a second hinge, with the first hinge aligned horizontally along the body (29) and the second hinge is aligned vertically along the body (29).

4. The attendant module of any preceding claim, further comprising:
the body (29) comprising a front side and a back side with the first compartment (39) extending into the front side and the first door (30) connected to the front side;
electrical equipment (99) mounted within an interior of the body 29; and
a panel (35) mounted within the interior of the body (29), the panel (35) positioned between the first compartment (39) and the electrical equipment (99).

5. The attendant module of any preceding claim, further comprising a frame (60) mounted within an interior of the body (29), the frame (60) comprising:
a back (61);
arms (62) that extend outward from opposing sides of the back (61);
wherein the first compartment (39) is positioned between the arms (62); and
wherein the second compartment (49) is positioned outward from one of the arms (62) such that the one arm (62) extends between the first compartment (39) and the second compartment (49).

6. The attendant module of any preceding claim, further comprising:
a third compartment (59) that extends into the first side of the body (29); and
a third door (50) connected to the body (29) at the third compartment (59) and is movable between an open position and a closed position.

7. The attendant module of any preceding claim, wherein the first door (30) is positioned at an opening of the first compartment (39) and the first door (30) is smaller than the opening to form a gap (70) between the body (29) and the first door (30) when the first door (30) is in the closed position, the gap (70) configured to enable smoke in the first compartment (39) to exit from the first compartment (39) when the first door (30) is in the closed position.

8. The attendant module of any preceding claim, further comprising input devices (98) on the body (29) to control electrical equipment (99) that is positioned within an interior of the body (29).

9. The attendant module of any preceding claim, wherein a swing range of the first door (30) is less than 90° so a top edge (32) of the first door (30) remains vertically above a bottom edge (33) of the first door (30) in the open position.

10. The attendant module of claim 5, wherein the first compartment (39) and the second compartment (49) are on opposing sides of the frame (60).

11. The attendant module of any preceding claim, wherein the one or more holsters (34) comprise an open end (38) that is positioned at a top edge (32) of the first door (30), wherein the first door (30) is pivotally mounted to the frame (60) for the top edge (32) to be vertically above a bottom edge (33) when the first door (30) is in an open position.

12. The attendant module of claim 4, further comprising:
video electronics (99) positioned within the interior space of the body (29);
wherein the panel (35) is positioned between the video electronics (99) and the first compartment (39) to segregate the first compartment (39) from the video electronics (99).

13. The attendant module of claim 12, further comprising input devices (98) positioned on an exterior of the body (29), the input devices (98) configured to operate the video electronics (99).

14. A method of mounting an attendant module to a monument within a cabin area (103) of an aircraft, the method comprising:
mounting a frame (60) to a base (90) that is mounted to the monument (111) with the base (90) comprising electrical equipment (99) configured to operate components that are within the cabin area (103);
mounting a panel (35) to the frame (60) with the panel (35) positioned in front of the electrical equipment (99);
mounting a body (29) of the attendant module to the base (90);
aligning a first opening (81) of the body (29) along a front side (21) of the attendant model and in front of the panel (35);
aligning a second opening (82) of the body (29) along a lateral side (23) of the attendant model at an electrical port (48);
positioning a first door (30) at the first opening (81) with the first door (30) movable to a closed position that extends across the first opening (81); and
positioning a second door (4)0 at the second opening (82) with the second door (40) movable to a closed position that extends across the second opening (82).

15. The method of claim 14, wherein mounting the body (29) to the base (90) comprises positioning the body (29) over the frame (60) and over the panel (35).
